# EUROPEAN PATENT APPLICATION

(11) **EP 2 061 299 A2**
(43) Date of publication of application: **20.05.2009**
(21) Application number: 08169156.0
(22) Date of filing: 14.11.2008
(51) Int. Cl.: H05K 13/08

(54) **Method for Producing Printed Circuit Board Assembly and Mounting Device**

(30) Priority: 16.11.2007 JP 2007298075
(71) Applicant: Fujitsu Ltd., Kawasaki-shi, Kanagawa 211-8588 (JP)
(72) Inventor: Okada, Hiroyuki, Ishikawa 929-1196 (JP); Iida, Mitsuhiro, Ishikawa 929-1196 (JP)
(74) Representative: Holtby, Christopher Lawrence

(57) **Abstract**

A mounting device for mounting an component onto a circuit board may include: a first memory to store mounting data associating a placement of a component in the mounting device with a mounting position of the component on the circuit board, a second memory to store reference data corresponding to a reference component, a placement data changer to change data specifying the placement of the component in the mounting device to data specifying a placement of the reference component in the mounting device, a mounting position data changer to change data specifying a mounting position of the component on the circuit board to data specifying a mounting position of the component that is previously indicated, and a mounter to mount the component at a position on the circuit board specified by the changed mounting data.

## Description

### CROSS-REFERENCE TO RELATED APPLICATIONS

This application is based upon and claims the benefit of priority of the prior Japanese Patent Application No. 2007-298075, filed on November 16, 2007, the entire contents of which are incorporated herein by reference.

### BACKGROUND

1. Field

Example embodiments discussed herein are related to a method for producing printed circuit board assemblies and a mounting device for mounting electronic components.

2. Description of the Related Art

A mounting device for mounting electronic components may be used once setups such as setting cassettes to a component feeder, removing cassettes from the component feeder, setting reels onto cassettes and removing reels from cassettes in changeovers of printed circuit board assemblies are performed. Then, the mounting device is used to mount electronic components onto printed circuit boards for fabricating printed circuit board assemblies.

Accordingly, the mounting device is an automated device having a component feeder including cassettes or trays in which are loaded electronic components and mounting heads for conveying electronic components from the cassettes or the trays onto printed circuit boards by suctioning and mounting the components onto the boards. The component feeder is provided with lanes in which the cassettes or the trays are set. Each lane is assigned a unique number. To mount appropriate components at appropriate positions on the printed circuit boards, the cassettes or the trays on which appropriate electronic components are set are placed in appropriate lanes of the component feeder. The cassettes or the trays are placed into the lanes according to mounting data, which is used to operate the mounting device.

The mounting data is broadly classified into two categories, placement data and NC (Numerical Control Machining) data. Placement data is data associating an electronic component to be mounted onto a printed circuit board with a number, or address, that is assigned to the component feeder in which a reel around which the electronic component is wrapped, i.e., the number assigned to a lane in which the reel are placed. NC data is data associating the number assigned to the component feeder in which the reel is placed (and around which the electronic component to be mounted onto the board is wrapped), e.g., the number assigned to the lane in which the reel is placed, with coordinates specifying a mounting position of the electronic component on the printed circuit board.

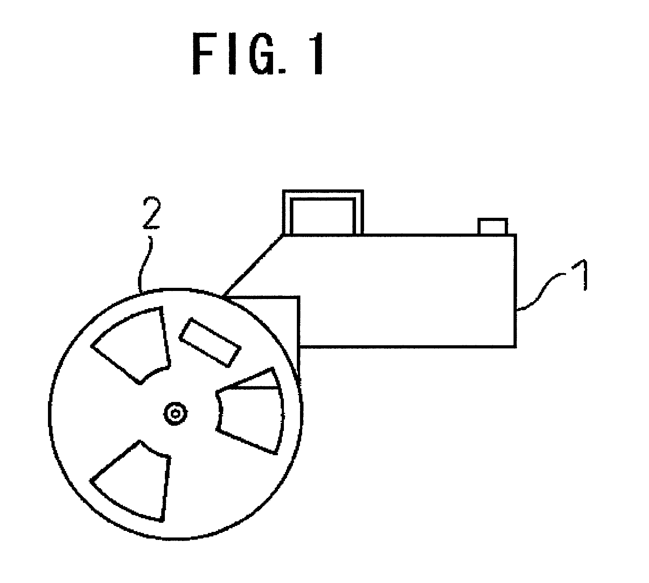

FIG. 1 is a side view of a cassette to be placed into the mounting device. In FIG. 1, reel 2 is set onto cassette 1. As shown in FIG. 1, cassette 1 may be set with a reel 2 around which a single type of an electronic component fixed onto a tape-like material is wrapped. Because electronic components are minuscule for high density mounting in recent years, reels are correspondingly minuscule. In order to save space in the mounting device, cassettes on which a plurality of reels are used, and the reels have different types of electronic components wrapped there around..

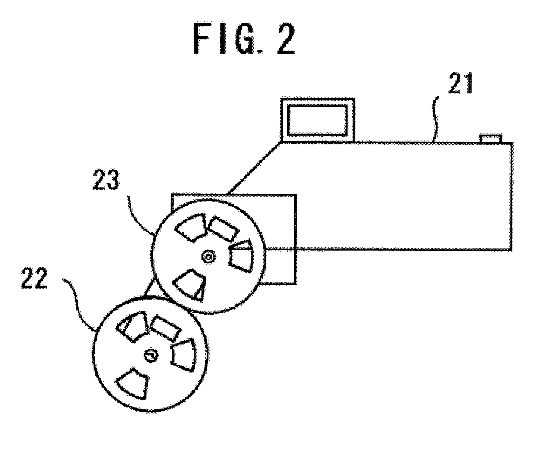

FIG. 2 is a side view of a cassette on which a plurality of electronic components are set. Particularly, FIG.2 shows a two-reel-cassette on which two types of electronic components are set. In FIG. 2, a first reel, 22, and a second reel 23 are set onto two-reel-cassette 21. The first type of electronic component fixed on a tape-like material is wrapped around the first reel 22. The second type of electronic component fixed on a tape-like material is wrapped around the second reel 23. Again, cassettes on which more than three reels are set are now in use. The mounting device recognizes that positions of a plurality of reels on a cassette correspond to each lane of the component feeder by reference to mounting data. For example, in FIG.2, the first reel 22 is placed in an odd-numbered lane, and the second reel 23 is placed in an even-numbered lane of the cassette, or the mounting device, respectively.

To mount electronic components onto a printed circuit board, firstly, reels having electronic components wrapped there around are set onto cassettes manually, or automatically by using any device for mounting reels onto the cassettes, according to the mounting data. Further, other electronic components that are not wrapped around the reels are set in trays by hand or automatically. For cassettes on which a plurality of the reels may be set, the reels are set thereon in an orderly manner. After setting the reels onto the cassettes, the cassettes are placed in the lanes of the component feeder by hand or automatically according to the mounting data.

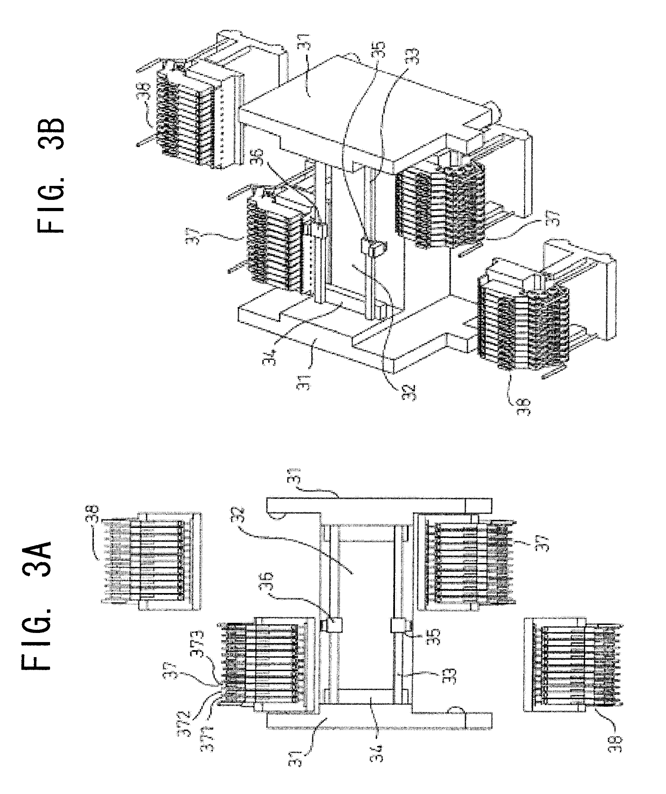

FIG. 3A shows a top view of an example of the mounting device. FIG.3B is a figure showing a perspective view of the mounting device. As shown in FIGS. 3A and 3B, two lots of cassettes are set on the mounting device. As shown in FIGS. 3A and 3B, the mounting device has frame 31, conveyor 32 for moving printed circuit boards, rail 33 for driving conveyor 32 in X-axis direction, rail 34 for driving conveyor 32 in Y-axis direction, heads 35 and 36 for conveying and mounting components set on cassettes onto printed circuit boards set on the conveyer by suctioning, a cart or a carriage 37 on which the first lot of the cassettes are set, and a second cart or a second carriage 38 on which the second lot of the cassettes are set. The mounting device fabricates a printed circuit board assembly by mounting electronic components onto a printed circuit board set on conveyor 32 according to mounting data. Cart 37 is provided a plurality of lanes that are assigned numbers 371, 372, 373 through n, in which cassettes are placed according to the mounting data. While the components set on the cassettes of the first lot is mounted onto the printed circuit boards set on conveyor 32 with the head 35 and 36, the second lot cassettes are prepared by setting the cassettes onto the cart or the carriage, or setting electronic components onto the cassettes.

### SUMMARY

At least one embodiment, of the present invention, as described herein provides a production method of printed circuit board assemblies and the use of a mounting device for mounting electronic components by which setups such as the removal of reels from cassettes and the setting of reels onto cassettes may be streamlined and the downtime of the production line during the changeovers may be curtailed.

Accordingly, in one embodiment of the present invention there is provided a mounting device for mounting a component onto a circuit board. Such a mounting device includes a first memory to store mounting data associating a placement of a component in the mounting device with a mounting position of the component on the circuit board, a second memory to store reference data corresponding to a reference component, a placement data changer to change data specifying the placement of the component in the mounting device to data specifying a placement of the reference component in the mounting device, a mounting position data changer to change data specifying a mounting position of the component on the circuit board to data specifying a mounting position of the component that is previously indicated, and a mounter to mount the component at a position on the circuit board specified by the changed mounting data.

### BRIEF DESCRIPTION OF THE DRAWINGS

Embodiments are illustrated by way of example and not limited by the following figure(s).

FIG. 1 illustrates a schematic view of a cassette;

FIG. 2 illustrates a perspective view of a two-reel cassette;

FIG. 3A is a top view of a mounting device;

FIG. 3B is a perspective view of the mounting device;

FIGS. 4A-4B are examples of mounting data, in accordance with at least one embodiment of the present invention;

FIG. 5 is a block diagram illustrating a structure of the mounting device, in accordance with at least one embodiment of the present invention;

FIG. 6 is a flow chart illustrating operations of the mounting device shown in FIG. 5, in accordance with at least one embodiment of the present invention;

FIGS. 7A- C are reference drawings for the flow chart shown in FIG. 6, assuming that two-reel cassettes are used, in accordance with at least one embodiment of the present invention;

FIG. 8A shows a table providing original placement data and changed placement data of electronic components, in accordance with at least one embodiment of the present invention;

FIG. 8B shows a table providing correlation between original NC data and changed NC data, in accordance with at least one embodiment of the present invention;

FIG. 9 is a block diagram illustrating a structure of the mounting device, in accordance with at least one embodiment of the present invention ;

FIGS. 10A-B shows a flow chart illustrating operations of a processor, in accordance with at least one embodiment of the present invention;

FIG. 11 is a reference drawing of the flow chart shown in FIGS. 10A and 10B, in accordance with at least one embodiment of the present invention;

FIG. 12 is a block diagram illustrating a structure of the mounting device, in accordance with at least one embodiment of the present invention;

FIGS. 13A-B shows a flow chart illustrating the production method of printed circuit board assemblies using a mounting device, in accordance with at least one embodiment of the present invention;

FIG. 14 is a reference drawing of the flow chart shown in FIGS. 13A and 13B, in accordance with at least one embodiment of the present invention; and

FIG. 15 illustrates an example of the production process of printed circuit board assemblies, in accordance with at least one embodiment of the present invention.

### DETAILED DESCRIPTION OF EXAMPLE EMBODIMENTS

Recently, there is a tendency to fabricate a wide variety of printed circuit board assemblies in small quantities. For that reason, setups of a mounting device for mounting electronic components onto the printed circuit during changeovers increase. Consequently, suspensions of a production line may occur, which contributes to decrease productivity.

Setups that may cause the suspensions of the production line include: replacing cassettes on which a plurality of components are set, replacing common components, and fabricating printed circuit board assemblies in small quantities. These setups are described below.

### 1) Replacing cassettes on which a plurality of components are set

Where the same types of the components are mounted onto different types of boards, placements of the common components in the mounting device may change for each board. With the changes of the placements of the common components, orders to place the cassettes into the mounting device or orders to set the reels onto the cassettes may change. Components that may be mounted onto the different types of boards are referred to as "common components" hereinafter.

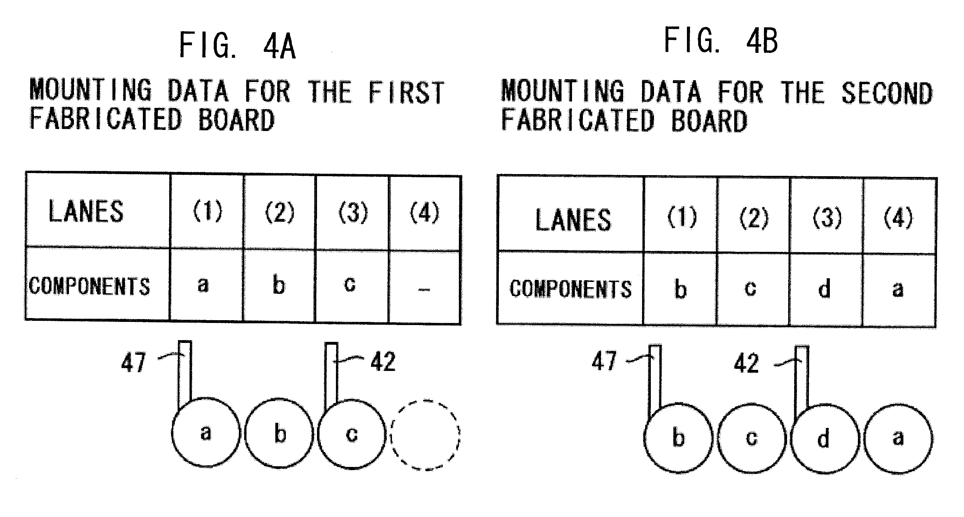

FIG. 4 shows the example of mounting data for printed circuit board assemblies to be fabricated firstly, namely first printed circuit board assembly. As shown in FIG. 4A, electronic component "a" is set in lane 1, electronic component "b" is set in lane 2, electronic component "c" is set in lane 3 and no electronic component is set in lane 4. The mounting device reads out the mounting data as shown in FIG. 4 for each of the first printed circuit board assembly to be fabricated.

Whereas, FIG. 4B shows mounting data for a printed circuit board assembly to be successively fabricated after the first printed circuit board is fabricated, namely second printed circuit board assembly. As shown in FIG. 4B, electronic component "b" is set in lane 1, electronic component "c" is set in lane 2, electronic component "d" is set in lane 3 and electronic component "a" is set in lane 4.

Electronic components "a", "b" and "c" are used for the first printed circuit board assembly and the second printed circuit board assembly. For the first printed circuit board assembly, the reel which electronic component "a" is wrapped around is set on cassette 41 placed in lane 1. For the second printed circuit board assembly, the reel which electronic component "a" is wrapped around is set on cassette 42 placed in lane 4.

For the first printed circuit board assembly, the reel which electronic component "b" is wrapped around is set on cassette 41 placed in lane 2. For the second printed circuit board assembly, the reel which component "b" is wrapped around is set on cassette 41 placed in lane 1.

The reel which electronic component "c" is wrapped around is set on cassette 42 placed in lane 3 for the first printed circuit board assembly. The reel which electronic component "c" is wrapped around is set on cassette 41 placed in lane 2 for the second printed circuit board assembly.

Some of the electronic components used for the first printed circuit boards and the second printed circuit boards are common, reels with the common electronic components are wrapped around may be placed in different lanes of the mounting device. Thus, removing and resetting the electronic components or cassettes from and into the lanes of the mounting device may be performed during the changeover. Accordingly, replacing cassettes on which a plurality of components are set may include removing the cassettes from the mounting device and removing the reels from the cassettes or resetting the reels onto the cassettes.

### 2) Replacing common components

Where a certain type of common component has been placed in a different position of the mounting device, or when a electric component different from the common component has been occupying a specific position of the mounting device, the electronic component has to be replaced to an appropriate position of the mounting device in changing a model of printed circuit board assemblies to be fabricated. In the changeover, the fabricating line including the mounting device is halted during replacing the cassettes. The downtime has an effect upon a utilization factor of the mounting device.

### 3) Fabricating printed circuit board assemblies in small quantities.

Assuming cases that: a) electronic components are set onto a cassette that a plurality of electronic devices may be set; or b) a setting order of the electronic components has to be changed, and the cassette that a plurality of electronic components may be set is in use to fabricate a first printed circuit boards. In any of these cases, the electronic components set on the cassettes may not be replaced, or a setting order of the components onto the cassettes may not be changed, until a fabrication of the first printed circuit boards is finished.

In a setup that includes replacing the components on the cassettes and changing the setting order on the components, operations of equipments, including the mounting device, are ceased after the first printed circuit boards. In fabricating printed circuit board assemblies in small quantities, such a setup may occur more frequently, therefore setups increase in number, reducing the utilization factor of the mounting device.

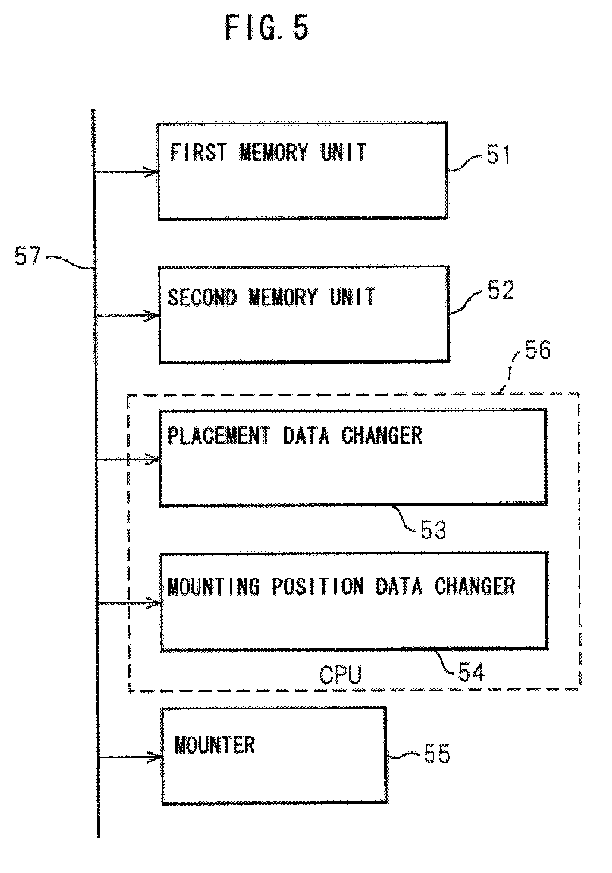

FIG. 5 is the block diagram illustrating an embodiment of the mounting device, in accordance with at least one embodiment of the present invention. The mounting device for mounting electronic components on printed circuit boards shown in FIG. 5 includes a first memory unit 51 for storing mounting data associating placements of electronic components in the mounting device with mounting positions of the electronic components on printed circuit boards for each printed circuit board assembly, and a second memory unit for storing reference mounting data corresponding to reference electronic components, which are used in changing the mounting data; placement data changer 53 for changing placements of electronic components to be mounted on a printed circuit board in the mounting device specified with mounting data for the printed circuit board assembly. The mounting device further has mounting position data changer 54 for changing mounting positions of electronic components to be mounted on a printed circuit board specified with mounting data for the board to former mounting positions that correspond to the placements of the components, and mounter 55 for mounting electronic components at specified positions on a printed circuit board specified with the changed mounting data.

Placement data changer 53 and mounting position data changer 54 are implemented by CPU 56. Memory unit 51, memory unit 52, placement data changer 53, mounting position data changer 54 and mounter 55 are connected to bus 57.

Mounter 55 has a head 35 or 36 shown in FIG. 3. Mounter 55 mounts electronic components wrapped around reels at positions on printed circuit boards specified with the changed mounting data by suctioning the components with heads 35 and 36. First memory unit 51 may store mounting data relating to all printed circuit board assemblies to be fabricated within a specific period of time, i.e., 24 hours.

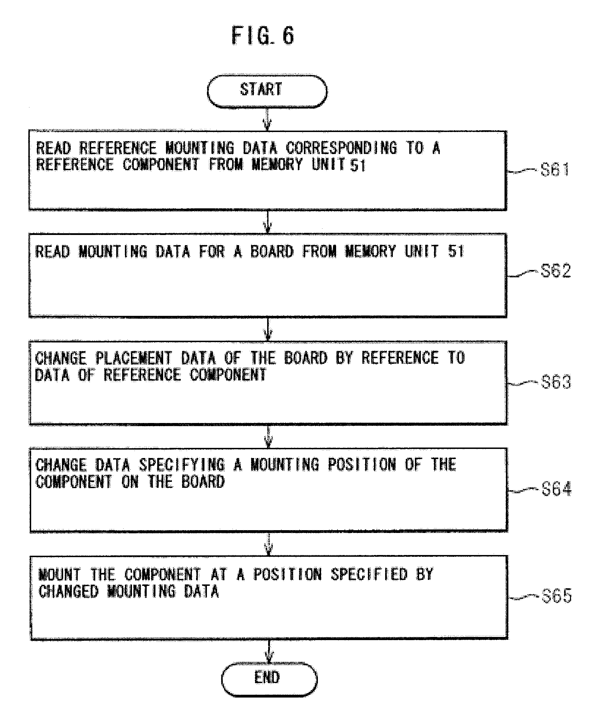

FIG. 6 is a flow chart illustrating the operations of the mounting device shown in FIG. 5, in accordance with at least one embodiment of the present invention. First, the mounting device reads out reference mounting data corresponding to reference electronic components, which are used in changing mounting data, from memory unit 52 at S61.

Successively, the mounting device reads out mounting data corresponding to any printed circuit board assembly from memory unit 51 at S62. Then, the mounting device changes data indicating placements of electronic components to be mounted on a printed circuit board in the mounting device specified with mounting data for the board by reference to placements of reference electronic components in the mounting device specified with the mounting data at S63. Further, the mounting device changes mounting position of electronic components, to be mounted on the board as specified by the mounting data for the board, to mounting positions corresponding to former placements at S64.

Next, the mounting device mounts electronic components at positions specified with the changed mounting data on the printed circuit board assembly at S65.

Where any electronic components specified with the mounting data are not set on the cassettes, the electronic components is picked up from an inventory location, then set onto a position of the cassette indicated by the changed mounting data.

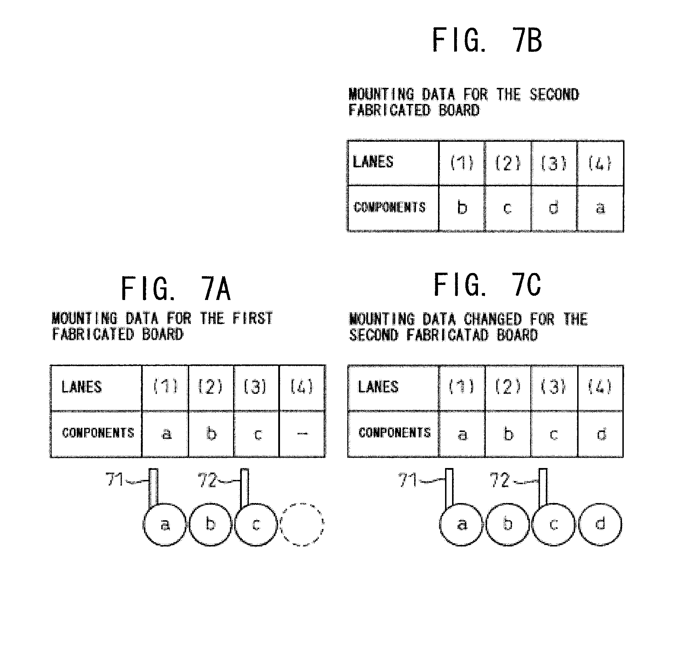

FIGS. 7A through 7C are drawings showing a detailed operation corresponding to the flow chart shown in FIG. 6, assuming that two-reel cassettes are used, in accordance with at least one embodiment of the present invention.

The mounting data read out from memory unit 51 shown in FIG. 7A specifies that electronic component "a" is set in lane 1, electronic component "b" is set in lane 2, electronic component "c" is set in lane 3 and no electronic component is set in lane 4. Two reels, the first reel which electronic component "a" is wrapped around and the second reel which electronic component "b" is wrapped around, are set on two-reel cassette 71 to be placed in the mounting device. The first reel corresponds to the first lane which is an odd-numbered lane, and the second reel corresponds to the second lane which is an even-numbered lane. The third reel which electronic component "c" is wrapped around is set on cassette 72. In the example shown in FIG. 7A, the fourth reel is not set at a position on cassette 72 that is designated for the fourth reel. Otherwise, the fourth reel with no electronic component may be set onto the cassette 72.

FIG. 7B shows former mounting data, which is the mounting data that is not changed, for a second printed circuit board assembly to be fabricated. FIG. 7C shows changed mounting data for the second printed circuit board assembly. The mounting data shown in FIG. 7B specifies that electronic component "b" is set in lane 1, electronic component "c" is set in lane 2, electronic component "d" is set in lane 3 and electronic component "a" is set in lane 4. Electronic components a, b and c are common in the mounting data shown in FIGS. 7A and 7B. However, the lanes in which those common components are set are different. Therefore, the reels have to be removed from the mounting device and then reset.

In this embodiment, a printed circuit board assembly corresponding to the mounting data shown in FIG. 7A is defined as a reference board. Of electronic components included in mounting data for a successive printed circuit board assembly, which is a printed circuit board assembly to be fabricated after printed circuit boards that are presently fabricated, electronic components that are common to electronic components included in mounting data for a reference board, in other words, the common components, are changed their placements in the mounting device to the same placements of the electronic components mounted onto the reference board. Electronic components a, b and c are common in FIGS. 7A and 7B. Therefore, the mounting data for the successive printed circuit board assemblies are changed to set common components "a" through "c" in lanes 1 through 3 respectively as shown in FIG. 7C, and electronic component "d" is set in lane 4 as shown in FIG. 7C. Where different type of printed circuit board assemblies are fabricated subsequent to the fabrication of the reference boards, electronic components "a" and "b" are set on cassettes 71 and electronic components "c" are set on cassettes 72. Therefore, setups such as removing the reels from the cassettes and resetting the reels onto the cassettes are not performed in the changeover as shown in FIG. 7A.

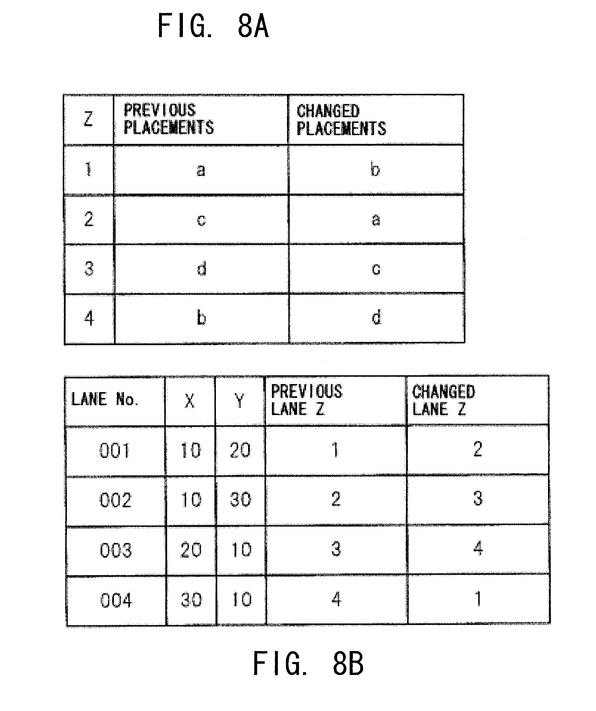

FIG. 8A shows the placements specified with former mounting data and changed mounting data, in accordance with at least one embodiment of the present invention. FIG. 8B shows NC data included in former mounting data and changed mounting data, in accordance with one or more embodiments of the present invention. All of "z" in FIGS. 8A and 8B refer lane numbers of the mounting device in which reels around which electronic components are wrapped are placed. In FIGS. 8A-8B, the placement data, 1-a, 2-c, 3-d and 4-b are rearranged to agree with the placement data of the reference boards, 1-b, 2-a, 3-c and 4-d as shown in FIG. 8A. Hence the placement data for the successive printed circuit board assembly is changed to the same placement of the reference board, the cassettes and the reels used for the reference board are used for the successive printed circuit board. In some cases, no common components are used for a reference board and a successive printed circuit board assembly. For instance, electronic component "d" is included in the placement data for the successive printed circuit board assembly shown in FIG. 7B, but not in the placement data for the reference board shown in FIG. 7A. Thus, electronic component "d" not to be fabricated on the reference boards is newly assigned to lane 4 as shown in FIG. 7C.

The NC data are changed with the change of the placement data to correct coordinates specifying mounting positions. FIG. 8B shows an example of data associating line numbers and positions of electronic components correspond to the line numbers on a printed circuit board, in other words, X-Y coordinates, with lane numbers of the mounting device to which the electronic components are assigned. For instance, electronic component "a" formerly assigned to lane 1 is reassigned to lane 2 as shown in FGI. 8A after the component is rearranged. Therefore, the component corresponds to line number 001 is reassigned from lane number 1 to lane number 2. That is to say, the X-Y coordinate of the common component, e.g., electronic component "a", are not changed where the lane in which the component is placed is changed. In other words, electronic component "a" is mounted at the same position specified with the former mounting data by using the changed data. As with the electronic component "a", NC data for the other components are changed in the same manner.

As illustrated by FIGS. 8A-8C, the placement data for a single printed circuit board assembly is changed, e.g., to the same placement data for the reference board. However, electronic components are mounted on a great number of printed circuit boards in practice. An example of mounting data that are used to mount electronic components on a large number of printed circuit boards is described below.

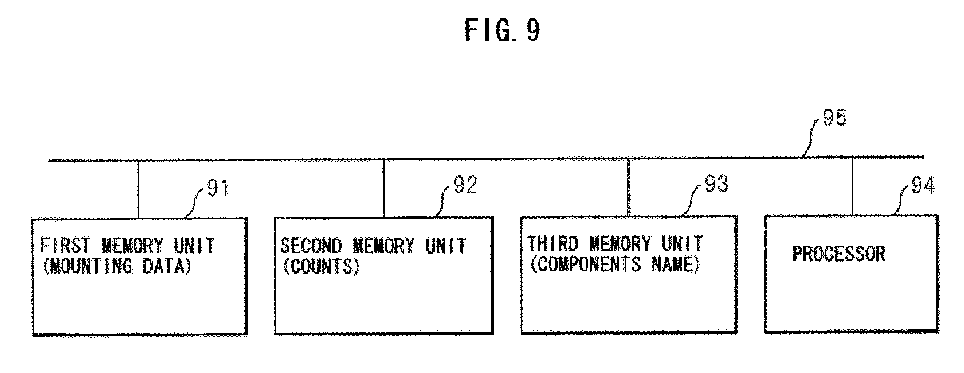

FIG. 9 is the block diagram illustrating a mounting device, in accordance with at least one embodiment of the present invention. The mounting device shown in FIG. 9 includes a first memory unit 91 for storing mounting data, and a second memory unit 92 for storing a number of components to be mounted onto each mounting surface of each board, which are also mounted onto surfaces of other boards, in other words, common components. The mounting device shown in FIG. 9 further has a third memory unit 93 for storing names of components to be mounted on mounting surfaces of printed circuit boards, and processor 94 for changing placement data and for changing NC data with the change of the placement data. Those sections of the mounting device mentioned above are on bus 95.

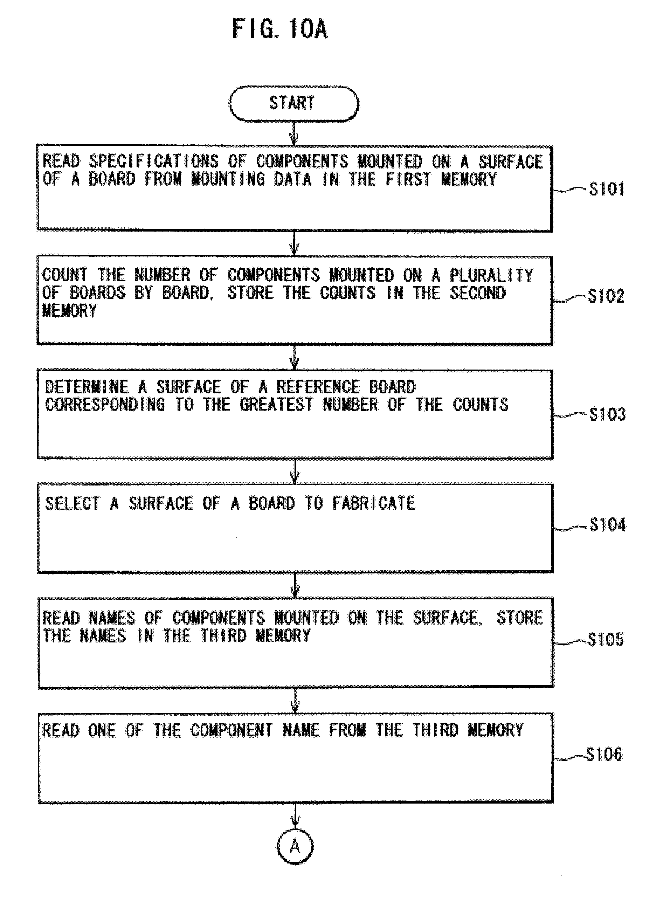

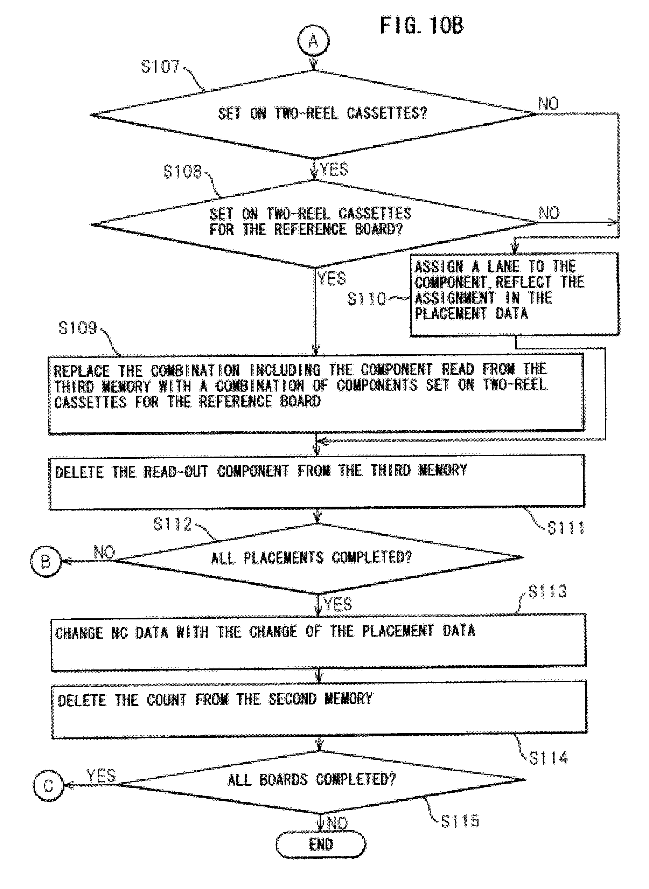

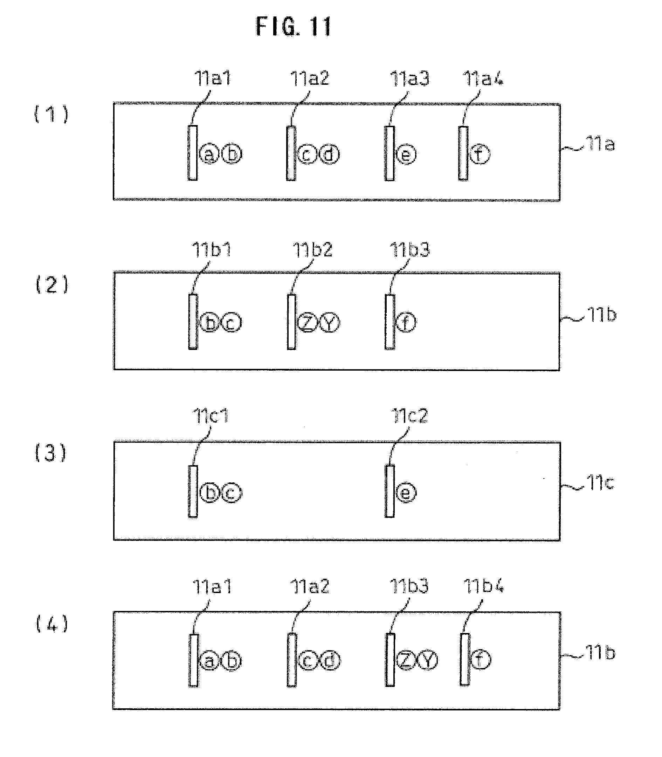

FIGS. 10A and 10B illustrate a flow chart of the operations of processor 94 shown in FIG. 9, in accordance with at least one embodiment of the present invention. The operations illustrated in the flow chart are described below with cases in which single-reel cassettes and two-reel cassettes are used. FIG. 11 is a reference drawing of the flow chart shown in FIGS. 10A and 10B, in accordance with at least one embodiment of the present invention.

[00623] At S101 shown in FIG. 10A, the mounting device reads specifications of electronic components to be mounted on each mounting surface of printed circuit board assemblies from the mounting data stored in first memory unit 91. Given that 11a, 11b and 11c shown in FIG. 11 are all boards to be fabricated. For the mounting surface of board 11a shown in FIG. 11, electronic components "a" and "b" set on two-reel cassette 11a1, "c" and "d" on two-reel cassette 11a2, "e" on single-reel cassette 11a3 and "f" on single-reel cassette 11a4 may be mounted thereon. For the mounting surface of board 11b shown in FIG. 11, electronic components "b" and "c" set on two-reel cassette 11b1, "z" and "y" on two-reel cassette 11b2 and "f" on single-reel cassette 11b3 may be mounted thereon. For the mounting surface of board 11c, electronic components "b" and "c" set on two-reel cassette 11c1 and "e" on single-reel cassette 11c2 may be mounted thereon.

At S102, the mounting device counts the number of the common components for each mounting surface of all boards based on the specifications read out from first memory unit 91, and then stores the number of the counts in second memory unit 92. For the surface of board 11a shown in FIG. 11, electronic components to be mounted thereon are "a", "b", "c", "d", "e" and "f". Electronic components "a" may not to be mounted on boards 11b and 11c. Electronic components "b" may be mounted on boards 11b and 11c. Electronic components "c" may be mounted on boards 11b and 11c. Electronic component "d" may not be mounted on boards 11b and 11c. Electronic component "e" may be mounted on board 11c. Electronic components "f" may be mounted on boards 11b and 11c. Of the electronic components "a", "b", "c", "d", "e"and "f" to be mounted on the surface of board 11a, "b", "c", "d", "e" and "f" are common to any of the other boards, and therefore a count of the common components is five. Likewise, the number of the common components to be mounted onto the surfaces of boards 11b and 11c are three, respectively.

At S113, the mounting device determines a board having the surface on which the greatest number of the components are mounted from among the counts stored in second memory unit 92 as a reference board. In the case shown in FIG. 11, number of counts "5" corresponding to board 11a is the greatest number, and thus board 11a is determined as the reference board.

At S104, the mounting device selects a mounting surface of a printed circuit board assembly to be fabricated. Here, the mounting surface of board 11b shown in FIG. 11 is selected.

At S105, the mounting device reads names of components to be mounted on the surface from the mounting board and then stores the names in third memory unit 93. For the mounting surface of board 11b shown in FIG. 11, components "b", "c", "z", "y" and "f" may be mounted. Thus, the name of the components may be stored in memory unit 93.

At S106, the mounting device reads out one of the name of the components, e.g., component "b", from third memory unit 93.

At S107 shown in FIG. 10B, the mounting device judges whether the name of the component read out from third memory unit 93, in this case, component "b", is the name of the component to be set on two-reel cassettes. In this case, the component "b" is the name of the component to be set on two-reel cassettes.

Where a judgment result at S107 is YES, the mounting device judges whether the name of the component is the name of the component to be set on the two-reel-cassette for the mounting surface of the reference board at S108. In this case, component "b" is the component to be set on two-reel cassette 11a1 for the mounting surface of reference board 11a.

When a result at S108 is YES, the mounting device changes placement data by replacing a combination of the component read out from third memory unit 93 at S106 and its combined used component with the combination of the components set on the two-reel cassette for the mounting surface of the reference board at S109. The changed placement data includes name of the component to be set as read from third memory unit 93 at S106.

As shown in FIG. 11, the placement data may be changed by replacing a combination of components "b" and "c", including component "b" to be mounted on a surface of board 11b, with a combination "a" and "b" to be set on cassette 11a1 for the surface of reference board 11a shown in FIG. 11, including component "b". To mount component "b", the combination of components set on cassette 11a1 for reference board 11a is applied as shown at the bottom of FIG. 11. Therefore, component "b" may be mounted onto board 11b without removing or resetting components "a" and "b" that may be mounted on board 11a from cassette 11a1.

Further, the placement data may be changed by replacing the combination of components "b" and "c" therein component "c" that may be mounted on the mounting surface of board 11b is included with the combination of components "c" and "d" therein component "c" that may be set onto two-reel cassette 11a1 for board 11a. To mount component "c" onto board 11b, cassette 11a2 on which components "c" and "d" are set is applied as shown at the bottom of FIG. 11. Component "d" set on cassette 11a2b may not be mounted. Therefore, component "c" may be mounted onto board 11b without removing or resetting any components from cassette 11a2 on which components "c" and "b" that may be mounted onto board 11a are set.

Where a judgment at S107 or S108 is NO, the mounting device associates the name of the component read out at S106 with a lane of the component feeder, and then the association is reflected in the placement data at S110. For instance, where a name of the component read out is "z" or "y", the judgment at S108 is NO. Thus, the mounting device associates the name of the component "z" or "y" that may be mounted on board 11b with lane 3 with which corresponds to cassettes 11b3 are associated at S110. Similarly, where a name of the component read out is "f", the judgment at S107 is NO. Thus, the mounting device associates the name of component "f" with the lane with which corresponds to cassettes 11b4 is associated at S110.

Thereafter, the mounting device deletes the name of the component read out from third memory unit 93 at S111.

At S112, the mounting device judges whether the rearrangement of the placement data for the surface is completed. When all data stored in third memory unit 93 are deleted, the mounting device judges that the rearrangement of the placement data for the surface is completed. Where the rearrangement of the placement data is not completed, S106 through S111 may be repeated.

After completing the rearrangement of the placement, the mounting device changes the NC data with the change of the placement data at S113. The description of the change operation of NC data may be omitted to avoid an overlap with a previously described embodiment.

Then the mounting device deletes the number of the count corresponds to the surface whose placement data are adjusted from second memory unit 92 at S114. At S125, the mounting device judges whether any boards whose data are unprocessed. Where no data are stored in second memory unit 92, the mounting device judges that all boards are processed, and completes a change process of the mounting data. When any data are remained in second memory unit 92, S103 through 114 may be repeated.

As described above, the placement data for the printed circuit board assembly is changed in compliance with the combinations of the electronic components, which may be mounted onto the reference board, on two-reel-cassettes for the reference boards. That is, the electronic components set onto the two-reel cassettes for a reference board are determined as reference electronic components. However, the reference electronic components set onto the two-reel cassettes are not necessarily used for a single board.

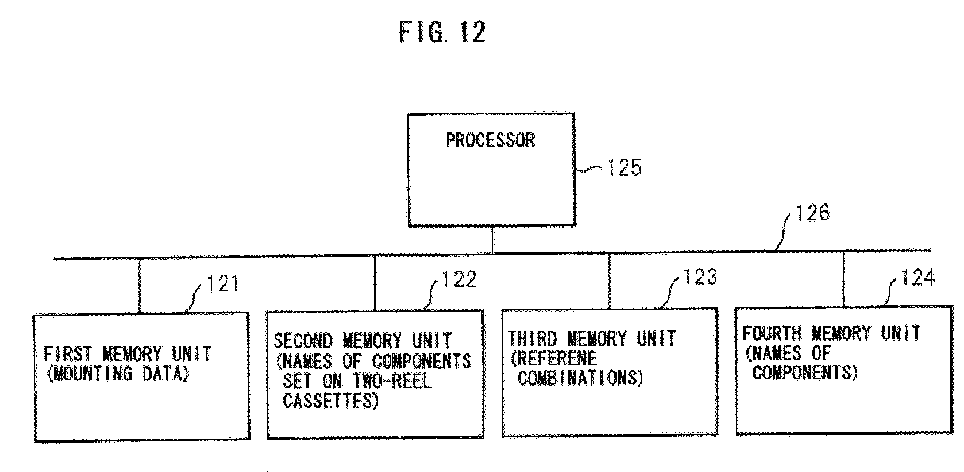

FIG. 12 is the block diagram illustrating the example of the structure of the mounting device. The mounting device shown in FIG. 12 has a first memory unit 121 for storing mounting data, a second memory unit 122 for storing names of electronic components to be set onto two-reel cassettes, a third memory unit 123 for storing reference combination of components, a fourth memory unit 124 for storing names of components to be mounted on boards to be fabricated, and processor 125 for changing placement data and NC data. Memory units 121 through 124 and processor 125 are on bus 126.

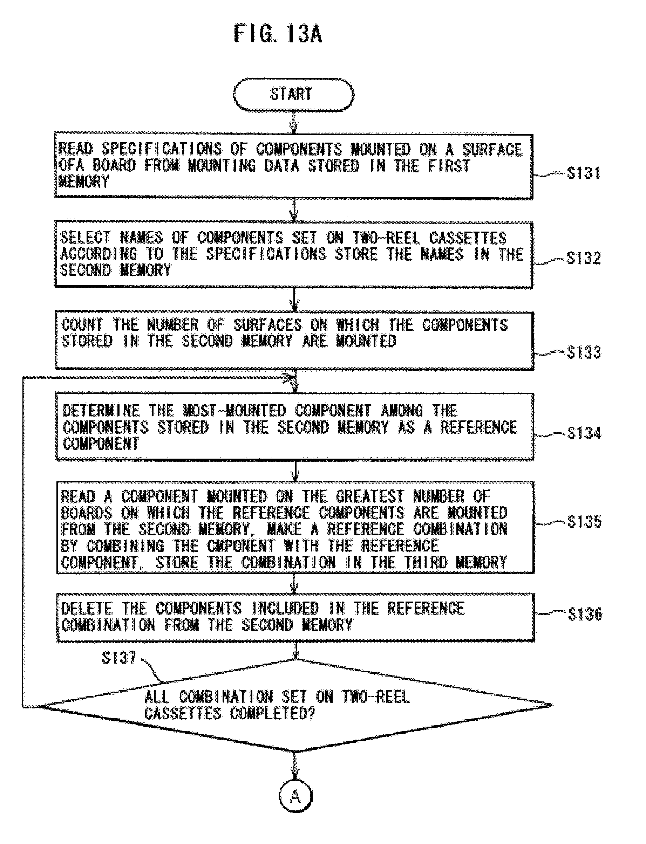

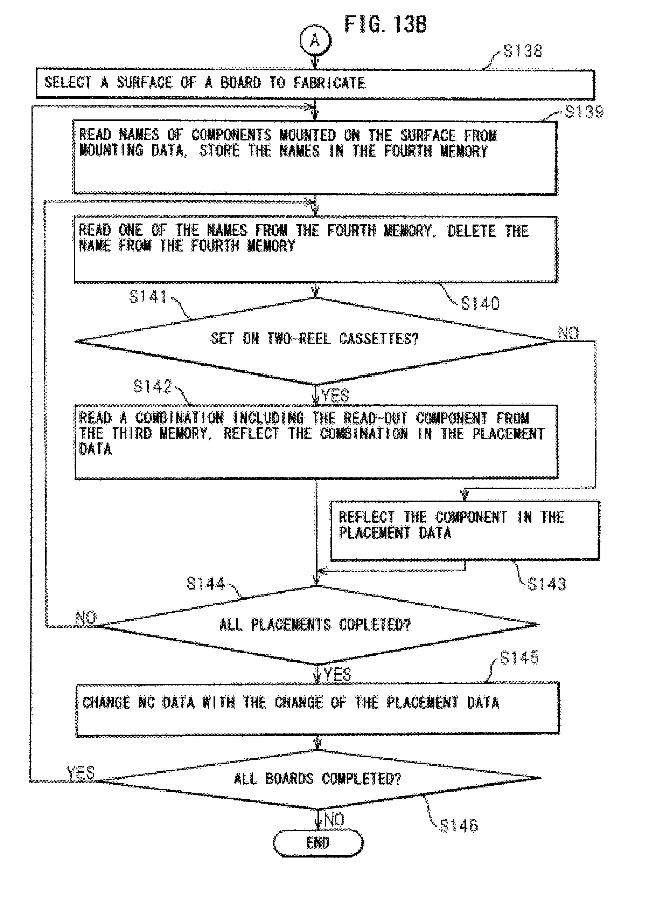

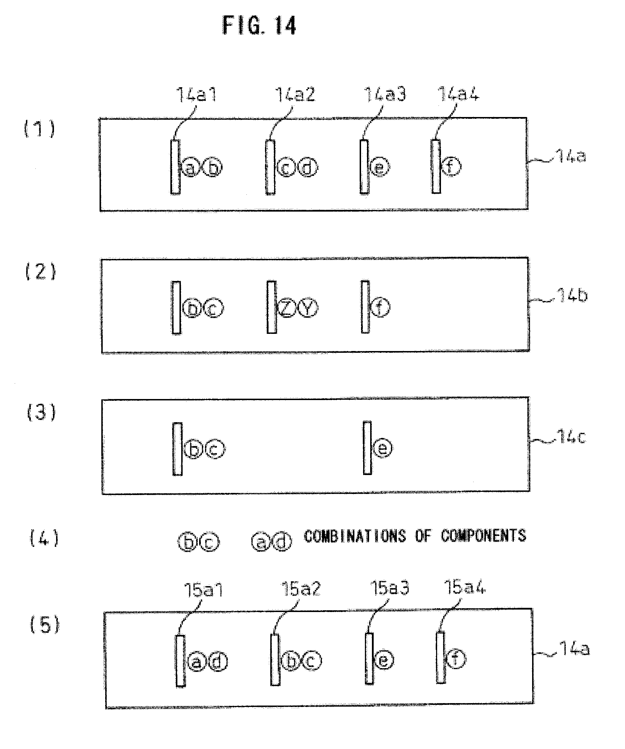

FIGS. 13A and 13B illustrate the flow chart of the operations of processor 125 shown in FIG. 12. Cases in which single-reel-cassettes and two-reel-cassettes are used will be disclosed. FIG. 14 is the reference drawing of the flow chart shown in FIGS. 13A and 13B.

At S131 shown in FIG. 13A, the mounting device reads specifications of electronic components to be mounted onto each surface of boards to be fabricated from mounting data stored in first memory unit 121. This is similar to S101 shown in FIG. 10.

At S132, the mounting device selects names of components to be set onto two-reel cassettes based on the read-out specifications, and then stores the selected names in second memory unit 122. In FIG. 14, electronic components "a", "b", "c", "d", "z" and "y" may be set onto the two-reel cassettes.

At S133, the mounting device counts the number of surfaces of boards on which each electronic component stored in first memory unit 122 is mounted. For example, electronic components "a" may be mounted onto only the surface of board 14a among the surfaces of boards 14a, 14b and 14c. Component "b" may be mounted onto the surfaces of three boards, 14a, 14b and 14c. Component "c" may be mounted onto the surfaces of three boards, 14a, 14b and 14c. Component "d" may be mounted onto the surface of board 14a only.

At S134, the mounting device selects an electronic component that may be mounted on the largest numbers of the surface of boards as a reference electronic component from among the electronic components stored in second memory unit 122. For instance, the most-mounted components are components "b" and "c" in FIG. 14. Provided that those most-mounted components are ranked in alphabetical order, component "b" is determined as the reference component.

At S135, the mounting device determines an electronic component that may be mounted on the greatest number of surfaces of boards on which the reference component are also be mounted, and then reads out a name of the component determined from second memory unit 122. Then the mounting device determines a reference combination of components that may be set on a two-reel-cassette by combining the electronic component read out from memory unit 122 and the reference component, and then stores the combination in memory unit 123. For the surface of board 14a shown in FIG. 14, component "a", "c" and "d" may be set on the two-reel-cassettes together with reference component "b". For the surface of board 14b, electronic components c, z and y may be set on the two-reel-cassettes together with reference component "b". For the surface of board 14c, electronic component c may be set on the two-reel-cassette together with reference component "b". Of the components mentioned above, the most-used component is component "c". Therefore, the mounting device reads out the most-mounted component, component "c", from second memory unit 122, combining component "c" and reference component "b", and then storing the combination in third memory unit 123 as a reference combination of components that are set onto the two-reel cassette.

At S136, the mounting device deletes the combination of components "b" and "c" stored in third memory unit 123 from second memory unit 122.

At S137, the mounting device judges whether all combinations of the electronic components that may be set onto the two-reel cassettes are determined. Where no data are stored in second memory unit 122, combining the electronic components are completed. If not, the mounting device repeats S134 through S136.

At S137, the components to be mounted on the two-reel-cassette, "a" and "d", are remains in second memory unit 122. The number of the surface of boards on which component "a" and "b" may be mounted is 1, respectively. Provided that the components are ranked in alphabetical order, component "a" is determined as a reference component. At S135, the mounting device reads out a name of component "d" from memory unit 122, combining a name of component "a" as a reference combination of the components to be set on the two-reel-cassette, storing the combination in third memory unit 123. At S136, the mounting device deletes the combination of "a" and "d" from second memory unit 122.

As the reference combinations "b" and "c", and "a" and "d" are deleted, no data are stored in second memory unit 122. Therefore, at S137, the components that may be set on the two-reel cassettes are judged that they are all combined.

Therefore, all combinations of the components to be set onto the two-reel-cassettes are determined preliminarily. FIG. 14 (4) shows all the combinations of the electronic components to be mounted on the two-reel-cassettes, "b" and "c", and "a" and "d", for boards 14a through 14c.

At S138 shown in FIG. 13B, the mounting device selects one surface of a printed circuit board assembly to be fabricated, e.g., the surface of board 14a shown in FIG. 14.

At S139, the mounting device reads names of components to be mounted on the surface from mounting data, and then stores the names in fourth memory unit 124. For the surface of board 14a, the electronic components to be read are components "a", "b", "c", "d", "e" and "f".

At S140, the mounting device reads out a name of a component to be mounted from fourth memory unit 124, and then deletes the name from fourth memory unit 124. For instance, the mounting device reads out the name of the component "a" from fourth memory unit 124, and then deletes the name of component "a" from fourth memory unit 124.

At S141, the mounting device judges whether the name of the component read out from fourth memory unit 124 is the component to be set onto the two-reel cassette. In this case, electronic component "a" is the component to be set onto the two-reel cassette.

When a judgment result at S141 is YES, the mounting device reads out a combination including the component read out as a reference combination from third memory unit 123, and then changes the placement data in accordance with the combination. Where the mounting device reads out a name of a component, e.g., component "a", from fourth memory unit 124, the combination including component "a" is the combination of "a" and "b". Thus, the mounting device reads out the combination from third memory unit 123, and then changes the placement data in accordance with the combination of "a" and "d". Thereafter, the component included in the combination that is stored in the fourth memory unit 124 is deleted. In this case, the name of component "d" included in the combination of "a" and "d" is stored in fourth memory unit 124, reflected in the placement data, and therefore the name may be deleted from fourth memory unit 124.

At S141, where a judgment result of S141 is NO, the mounting device reads out a component name from fourth memory unit 124, and then the name is included in the placement data at S143. For instance, electronic components "e" and "f" are the components to be set onto the single-reel cassettes. Thus, the component names are reflected in the placement data without combining with other components.

At S144, the mounting device judges whether the combinations for the placement data for the surface are all determined. Where no data are stored in fourth memory unit 124, the combinations for the placement data for the surface are all completed. In this case, components "b" and "c" are still stored in fourth memory unit 124, therefore a judgment result at S144 is NO. Thus the mounting device repeats S140 through S144. Then component "b" is combined with component "c", and the names of components "b" and "c" are deleted from fourth memory unit 124.

Originally, the placement data for board 14a shown in FIG. 14 specify that components "a" and "b" are set onto cassette 14a1, components "c" and "d" are set onto cassette 14a2, and component "e" on cassette 14a3; and component "f" on cassette 14a4. However, in accordance with the combinations determined at S135, the placement data specify that components "a" and "d" are set onto cassette 14a1, and components "b" and "c" are set onto cassette 14a2. Hence, components "e" and "f" are the components set onto the single-reel cassettes, the placement data does not change.

At S144, where no data remain in fourth memory unit 124, the mounting device changes NC data in accordance with the change of the placement data at S145.

At S146, the mounting device judges whether there are any boards in which mounting data are not adjusted. If so, S139 through S146 are repeated. After completing the adjustment of the mounting data for board 14a, board 14b and then board 14c are processed in a similar manner.

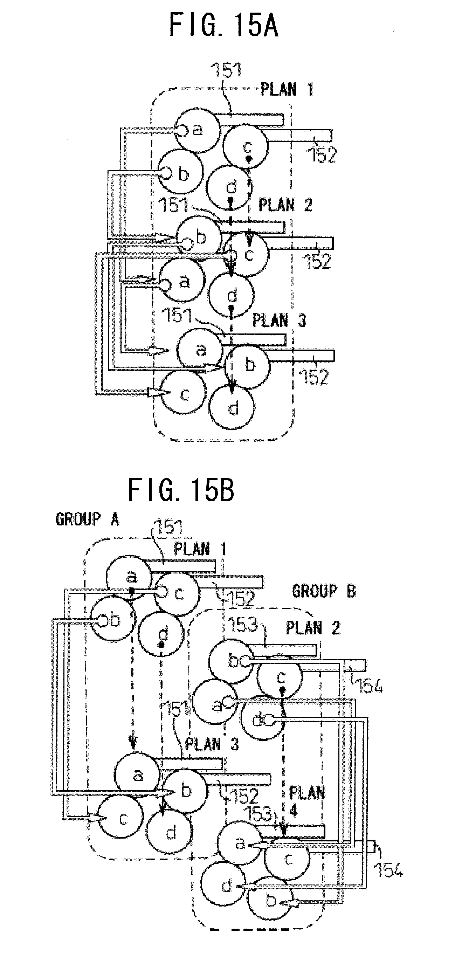

FIG. 15B illustrates a production method of printed circuit board assemblies, in accordance with at least one embodiment of the present invention. FIG. 15A illustrates the comparative example of a production method of the printed circuit board assemblies, in accordance with at least one embodiment of the present invention.

In FIG. 15A, components "a" and "b" are set onto cassette 151 in the order of "a" and "b". Components "c" and "d" are set onto cassette 152 in the order of "c" and "d". Those components are used to fabricate printed circuit board assemblies in plan 1. Those components are set onto a tape-like shape material, and are wrapped around reels. In plan 2, components "b" and "a" are set onto cassette 151 in the order of "b" and "a", and components "c" and "d" are set onto cassette 152 in order of "c" and "d" to fabricate other type of boards. In plan 3, components "a" and "c" are set onto cassette 151 in the order of "a" and "c", and components "b" and "d" are set onto cassette 152 in the order of "b" and "d to fabricate yet another type of boards.

In plans 1 and 2 shown in FIG. 15A, components "a" and "b" are common to cassettes 151. However, the setting order of the components in plan 1 is different from the setting order in plan 2, therefore, components "a" and "b" may not be used in plan 2 without changing the setting order. In plan 1, components "a" and "b" set onto cassette 151 are assigned to an odd-numbered lane and an even-numbered lane respectively. By contrast, in plan 2, components "b" and "a" set on cassette 151 are assigned to the odd-numbered lane and the even-numbered lane respectively. Thus, components "a" and "b" are removed from cassette 151 after completing plan 1, and then reset onto the cassette in the order of "b" and "a" for plan 2. Whereas, the setting orders of components "c" and "d" set onto cassettes 152 are the same in plans 1 and 2. Thus, components "c" and "d" are successively used in plan 2 without resetting.

In plan 3, components "a" and "c" are set onto cassette 151 in the order of "a" and "c". Therefore, components "b" and "a" for plan 2 are removed from cassette 151, and then components "a" and "c" for plan 3 are reset onto the cassette in the order of "a" and "c". For cassette 152, components "c" and "d" are set thereon in plan 2 in the order of "c" and "d". In plan 3, components "b" and "d" are set onto cassette 152 in the order of "b" and "d". Therefore, component "c" is replaced with component "b" to execute plan 3 successively.

As shown in FIG. 15A, resetting components may be required every changeover, resulting in suspensions of the production line. This production method of printed circuit board assemblies according to this embodiment is to reduce such downtime between changeovers.

FIG. 15B illustrates an example of the production method of printed circuit board assemblies. In FIG. 15B, plans 1 and 3 in which cassettes 151 and 152 are used are categorized into group A and plans 2 and 4 in which cassettes 153 and 154 are used are categorized into group B. A process described, e.g., vis-à-vis FIG. 15A, may be executed for groups A and B, respectively.

In plan 1 of group A, components "a" and "b" are set onto cassette 151, and components "c" and "d" are set onto cassette 152. In plan 3, components "a" and "c" are set onto cassette 151, and components "b" and "d" are set onto cassette 152. In plans 1 and 3, components "a" are set at the same position on cassettes 152. Thus, component "a" set on cassette 151 can be used without resetting when the production line changes from plan 1 to plan 3. Similarly, component "d" set on cassette 152 may be used without resetting when the production line changes from plan 1 to plan 3. Whereas, component "b" set on cassette 151 and component "c" set on cassette 152 are replaced with components "c" and "b" respectively in a changeover from plan 1 to plan 3.

In parallel with plans 1 and 3, setups of cassettes 153 and 154 for plans 2 and 4 of group B are performed, allowing a quick changeover from group A to group B by reducing the setup time.

Accordingly, various embodiments as described above can streamline setups such as removing reels from cassettes and resetting reels onto cassettes and can reduce the use of such setups. The reduction of these setups can save costs by, e.g., reducing (if not preventing) chances of losing electronic components during the setups. Setups for the mounting device such as removing reels from cassettes and setting reels onto cassettes also can be reduced, which in turn can reduce the downtime of printed circuit board production facility in which the mounting device is used. Further, printed circuit boards on which common components are mounted can be selected more correctly and/or efficiently.

Many features and advantages of the embodiments of the invention are apparent from the detailed specification and, thus, it is intended by the appended claims to cover all such features and advantages of the embodiments that fall within the true spirit and scope thereof. Further, because numerous modifications and changes will readily occur to those skilled in the art, it is not desired to limit the inventive embodiments to the exact construction and operation illustrated and described, and accordingly all suitable modifications and equivalents may be resorted to, falling within the scope thereof.
In any of the above aspects, the various features may be implemented in hardware, or as software modules running on one or more processors. Features of one aspect may be applied to any of the other aspects.
The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

## Claims

1. A method for producing a printed circuit board assembly by using a mounting device and mounting data, the mounting data providing a correspondence between placement of an electronic component in the mounting device and a mounting position of the electronic component on the printed circuit board, the method comprising:
reading first reference data corresponding to a reference electronic component;
reading second reference data corresponding to a printed circuit board assembly;
changing first position data, included in the mounting data and relating to one or more of a plurality of printed circuit boards, to the first reference data, the first position data specifying a placement of the electronic component in the mounting device;
changing second position data, included in the mounting data and relating to one or more of the plurality of printed circuit boards, to the second reference data, the second position data specifying a mounting position of the electronic component on the one or more printed circuit boards, the second reference data specifying a previous placement of the electronic component; and
mounting the electronic component at a mounting position on the printed circuit board specified with the changed mounting data, the printed circuit board is one of the plurality of printed circuit boards.

2. The method for producing a printed circuit board assembly according to claim 1, wherein the reference electronic component comprises an electronic component that is mounted onto at least one reference printed circuit board that is one of the plurality of printed circuit boards.

3. The method for producing a printed circuit board assembly according to claim 2, wherein changing the first position data comprises:
changing the first position data included in the mounting data for the reference printed circuit board in the mounting device to data specifying a placement of the electronic component included in the mounting data for the at least one reference printed circuit board in the mounting device.

4. The production method of a printed circuit board assembly according to claim 2 or 3, wherein the reading the mounting data for the printed circuit board, the changing the first position data, and the changing the second position data are executed for a surface of each of the plurality of printed circuit boards, respectively.

5. The production method of a printed circuit board assembly according to claim 4, the method further comprising:
determining a surface of the at least one reference printed circuit board by at least,
counting the number of common electronic components to be mounted onto a surface of a printed circuit board and a surface of one or more other printed circuit boards of the plurality of printed circuit boards; and
determining a surface of a printed circuit board corresponding to the greatest number of the counts counted in said count operation as a surface of the at least one reference printed circuit board.

6. The production method of a printed circuit board assembly according to any preceding claim, wherein the mounting the electronic component comprises:
placing a cassette on which at least one type of electronic component is set into place in the mounting device;
taking out the electronic component from the cassette placed in the mounting device; and
mounting the taken-out electronic component at a mounting position on the printed circuit board according to said changed mounting data.

7. The production method of a printed circuit board assembly according to any preceding claim, wherein the reference electronic component is set onto at least one cassette on which a plurality of electronic components are set, and the mounting device is set with at least one cassette on which a plurality of types of electronic components are set.

8. The production method of a printed circuit board assembly according to claim 7, wherein
the reading the mounting data comprises reading a name of an electronic component included in a reference combination selected from among a plurality of combinations of components that are set onto a cassette from the mounting data.

9. The production method of a printed circuit board assembly according to claim 8, wherein changing the first position data comprises changing the first position data included in the mounting data for said printed circuit board specifying a placement of an electronic component that is identical type of an electronic component included in said reference combination in said mounting device to data specifying a placement of said electronic component included in the reference combination in said mounting device.

10. The production method of a printed circuit board assembly according to claim 8 or 9, the method further comprising:
determining the reference combination by at least combining a reference electronic component and another electronic component;
wherein the reference electronic component is an electronic component among a plurality of electronic components included in the mounting data, and which is mounted onto the greatest number of surfaces of the plurality of printed circuit boards, and the another electronic component is an electronic component that has the greatest number mounted onto a surface of any one of the plurality of printed circuit boards.

11. The production method of a printed circuit board assembly according to any preceding claim, wherein the at least one reference circuit board comprises a plurality of reference printed circuit boards that are classified into a plurality of groups, and an electronic component for one of the classified groups is set in the mounting device according to the changed mounting data while mounting data for the other said group is processed in the changing the first position data, the changing the second position data, and the mounting the electronic component.

12. A mounting device for producing a printed circuit board assembly by mounting an electronic component onto a printed circuit board, comprising:
a first memory unit to store mounting data for each type of the printed circuit boards, associating a placement of an electronic component in the mounting device with a mounting position of the electronic component on the printed circuit board;
a second memory unit to store reference data corresponding to a reference electronic component;
a placement data changer to change data included in the mounting data for any of the printed circuit board specifying the placement of the electronic component in the mounting device to data specifying a placement of the reference electronic component in the mounting device;
a mounting position data changer to change data included in the mounting data for the printed circuit board specifying a mounting position of the electronic component on the printed circuit board to data specifying a mounting position of the electronic component that is indicated before the mounting data is changed; and
a mounter to mount the electronic component at a mounting position on the printed circuit board specified by the changed mounting data.

13. The mounting device according to claim 12, wherein the reference electronic component comprises an electronic component that is mounted onto a single reference printed circuit board.

14. The mounting device according to claim 13, wherein the placement data changer comprises a changer that changes data specifying a placement in the mounting device of an electronic component that is an identical to an electronic component included in the mounting data for the reference printed circuit board among electronic components included in the mounting data for any of the printed circuit board to data specifying a placement of the electronic component included in the mounting data for the reference printed circuit board.

15. The mounting device according to claim 13 or 14, further comprising:
an executor to execute processes executed by the placement data changer and the mounting position data changer for each surface of the printed circuit board; and
a determination unit to determine a surface of the reference printed circuit board, the determination unit includes,
a reader to read a specification of an electronic component to be mounted onto each surface of printed circuit boards to be fabricated from the mounting data;
a counter to count a number of electronic components mounted onto a surface of a printed circuit board to be fabricated and a surface of other printed circuit board to be fabricated by surface of a printed circuit board, according to the specification of the electronic component read by the reader; and
a second determination unit to determine a surface corresponding to the electronic components that has the greatest counted number counted by the counter as a surface of the reference board.

16. The mounting device according to any of claims 12 to 15, wherein the mounter comprises:
a placement unit to place a cassette on which at least one type of electronic component is set into a place in the mounting device; and
a mounter to take out the electronic component from the cassette placed in the mounting device, and that mounts the electronic component at a mounting position on the printed circuit board in accordance with the changed mounting data.

17. The mounting device according to any of claims 12 to 16, wherein the reference electronic component is set onto at least one cassette on which a plurality of electronic components is set, and the mounting device is set with at least one cassette on which a plurality of types of electronic components are set.

18. The mounting device according to claim 17, wherein
the reference mounting data reader comprises a reader for reading a name of an electronic component included in a reference combination selected from among a plurality of combinations of electronic components that are set onto a single cassette from the mounting data.

19. The mounting device according to claim 18; wherein
the placement data changer comprises a changer for changing data specifying a placement, in the mounting device, of an electronic component that is identical to an electronic component included in the reference combination among electronic components included in the mounting data for the printed circuit board to data specifying a placement of the electronic component included in the reference combination in the mounting device.
